# EUROPEAN PATENT SPECIFICATION

(11) **EP 4 434 075 B1**
(45) Date of publication and mention of the grant of the patent: **14.10.2026**
(21) Application number: 22809524.6
(22) Date of filing: 09.11.2022
(51) Int. Cl.: H10P 10/00

(54) **FABRICATION OF A SEMICONDUCTOR DEVICE INCLUDING A QUANTUM DOT STRUCTURE**
HERSTELLUNG EINER HALBLEITERANORDNUNG MIT EINER QUANTENPUNKTSTRUKTUR
FABRICATION DE DISPOSITIF À SEMI-CONDUCTEURS COMPRENANT UNE STRUCTURE À POINTS QUANTIQUES

(30) Priority: 15.11.2021 US 202117454831
(43) Date of publication of application: 25.09.2024
(73) Proprietor: International Business Machines Corporation, Armonk, New York 10504 (US)
(72) Inventor: MOSELUND, Kirsten Emilie, 8803 Rüschlikon (CH); VICO TRIVINO, Noelia, 8803 Rüschlikon (CH); MAUTHE, Svenja, 8803 Rüschlikon (CH); SCHERRER, Markus, 8803 Rüschlikon (CH); TIWARI, Preksha, 8803 Rüschlikon (CH)
(74) Representative: IBM Deutschland GmbH
(86) International application number: PCT/IB2022/060792
(87) International publication number: WO 2023/084414

(56) References cited:
- US-B2- 8 809 093
- MAUTHE SVENJA ET AL: "High-speed III-V nanowire photodetector monolithically integrated on Si", NATURE COMMUNICATIONS, 11 September 2020 (2020-09-11), London, pages 4565 - 1, XP093021743, Retrieved from the Internet <URL:https://www.nature.com/articles/s41467-020-18374-z.pdf> [retrieved on 20230207], DOI: 10.1038/s41467-020-18374-z
- BAUMGARTNER YANNICK ET AL: "High-speed CMOS-compatible III-V on Si membrane photodetectors", OPTICS EXPRESS, vol. 29, no. 1, 4 January 2021 (2021-01-04), pages 509, XP093021707, Retrieved from the Internet <URL:https://opg.optica.org/directpdfaccess/bf988782-f48c-4eb8-8aa8b5aaea24da78_445638/oe-29-1-509.pdf?da=1&id=445638&seq=0&mobile=no> DOI: 10.1364/OE.414013

## Description

### BACKGROUND

Embodiments of the invention relate generally to a method for fabricating a semiconductor device including a quantum dot structure. Embodiments of the invention further relate to a device obtainable by such a method.

Integrated quantum optics has attracted high interest for optical quantum computing. First proof of principle demonstrations have proven qubit operations using photons.

Key devices for optical computing are single photon sources and single photon detectors. While first devices have been demonstrated, a scalable and highly controlled process is needed. Whereas single photon detectors based on superconducting nanowire technology are well established, there is a rising interest in scaled devices which can operate at a higher than normal temperature, for example and in particular at room temperature.

Single photon devices are often based on materials with a single quantum dot incorporated. The precise alignment of the quantum dot is crucial to achieve efficient single photon operation and allow for the fabrication of more advanced devices. Hence there is a need for a fabrication approach that enables a precise fabrication of quantum dot structures in semiconductor material systems.

Quantum dots are semiconductor particles made on a nanoscale which can transport electrons. Quantum dots have electrical and optical properties which differ than larger particles due to quantum mechanics. Mauthe Svenja et al., Nature Communications on September 11, 2020, pages 4565, discloses "High-speed III-V nanowire photodetector monolithically integrated on Si.".

### SUMMARY

According to a first aspect, the invention is embodied as method for fabricating a semiconductor device. The method includes providing a cavity structure, the cavity structure including a seed area including a seed material. The method further includes growing, within the cavity structure, a quantum dot structure in a first growth direction from a seed surface of the seed material and growing, in the first growth direction, a first embedding layer on a first surface of the quantum dot structure. The method further includes removing the seed material and growing, within the cavity structure, on a second surface of the quantum dot structure, a second embedding layer in a second growth direction. The second surface of the quantum dot structure is different from the first surface of the quantum dot structure and the second growth direction is different from the first growth direction.

According to an embodiment of a further aspect of the invention, a semiconductor device obtainable by a method according to the first aspect is provided.

According to an embodiment of a further aspect of the invention, a semiconductor device is provided which includes a quantum dot structure and a first embedding layer which has been epitaxially grown on a first surface of the quantum dot structure. The semiconductor device further includes a second embedding layer which has been epitaxially grown on a second surface of the quantum dot structure. The first surface of the quantum dot structure and the second surface of the quantum dot structure are arranged opposite to each other.

According to an embodiment of a further aspect of the invention, the proposed semiconductor structure may be placed within a resonant structure, such as a photonic crystal lattice, to provide enhanced emission in a resonant mode.

According to an embodiment of a further aspect of the invention, the proposed semiconductor structure may be configured with respect to waveguides and other passive structures to allow for ease of in or out coupling of light.

The steps of the first aspect of the invention may be performed in different orders as appropriate. Importantly, the growth of the QD may happen in the step immediately before the growth of the second embedding layer. This may reduce the impact of lattice mismatch from the seed layer.

Furthermore, the steps may also be combined as appropriate, i.e. that e.g. two or more steps may be performed together.

Advantages of the features of one aspect of the invention may apply to corresponding features of another aspect of the invention.

Embodiments of the invention will be described in more detail below, by way of illustrative and non-limiting examples, with reference to the accompanying drawings.

### BRIEF DESCRIPTION OF THE DRAWINGS

These and other objects, features and advantages of the present invention will become apparent from the following detailed description of illustrative embodiments thereof, which is to be read in connection with the accompanying drawings. The various features of the drawings are not to scale as the illustrations are for clarity in facilitating one skilled in the art in understanding the invention in conjunction with the detailed description. In the drawings:
FIGS.1a - 1j show enlarged top views of initial, intermediate and final structures formed during the stages of fabrication methods according to embodiments of the invention;
FIGS. 2a - 2j show corresponding enlarged cross-sectional views of the structures corresponding to the FIGS. 1a - 1j; and
FIG. 3 shows a flow chart of method steps of a method for fabricating a semiconductor structure according to embodiments of the invention.

### DETAILED DESCRIPTION

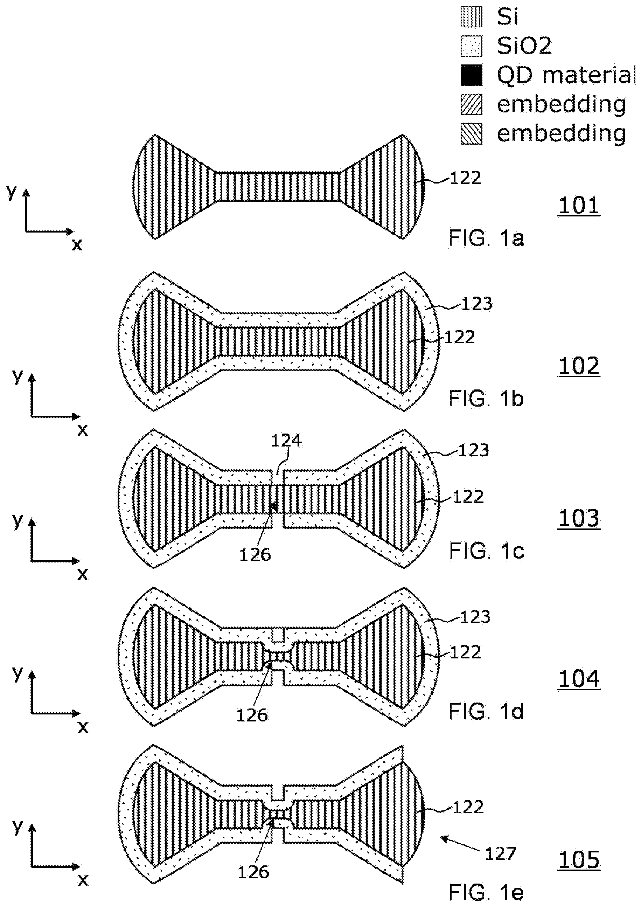

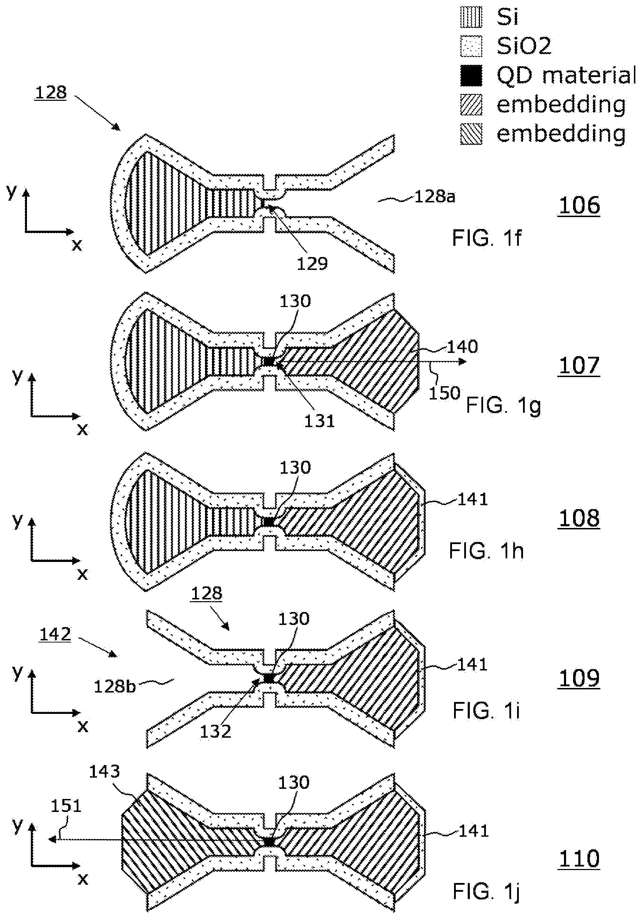

At first, in reference to FIGS. 1 - 3, some general aspects and terms of embodiments of the invention are described.

In any or all of the figures the dimensions may not be drawn to scale and may be shown in a simplified and schematic way to illustrate the features and principles of embodiments of the invention.

The term "cavity" here refers to a hollow space covered by a template into which a quantum dot (QD) and embedding layers may be grown. It is not to be confused with a resonant cavity used to fabricate a laser or other resonant device, although the "cavity" might be integrated into such a resonant structure.

The term "on" and "above" are used in this context, as is customary, to indicate orientation or relative position in a vertical or orthogonal direction to the surface of the substrate, in particular in a vertical z-direction.

The terms "lateral" or "laterally" are used in this context, as is customary, to indicate orientation generally parallel to the plane of the substrate, as opposed to generally vertically, or outwardly, from the substrate surface.

The term "arranged on a/the semiconductor substrate" shall be understood in a broad sense and shall include in particular embodiments according to which an intermediate layer, e.g. an insulating layer, is arranged between the substrate and the photonic crystal structure. Hence the term "arranged on the substrate" shall include the meaning arranged "above the substrate".

Methods according to embodiments of the invention allow to fabricate quantum dot structures, in particular a localized quantum dot, within an integrated active semiconductor device, in particular on silicon or silicon-on-insulator (SOI).

Embodiments of the invention perform a two-step epitaxial growth process within a cavity structure. By means of the two-step growth process a semiconductor material, in particular a group III-V semiconductor material is grown on opposite sides of the quantum dot structure. This allows for precise positioning of the quantum dot structure within the embedding materials. The embedding materials may be in particular semiconductor materials, in particular group III-V semiconductor materials.

According to embodiments, the growth of the quantum dot structure growth is performed immediately before the growth of the second embedding layer. This may reduce the impact of a lattice mismatch from the seed layer.

Methods according to embodiments of the invention may enable the fabrication of scaled single photon detectors or emitters.

FIGS. 1a - 1j show enlarged top views of initial, intermediate and final structures formed during the stages of fabrication methods according to embodiments of the invention.

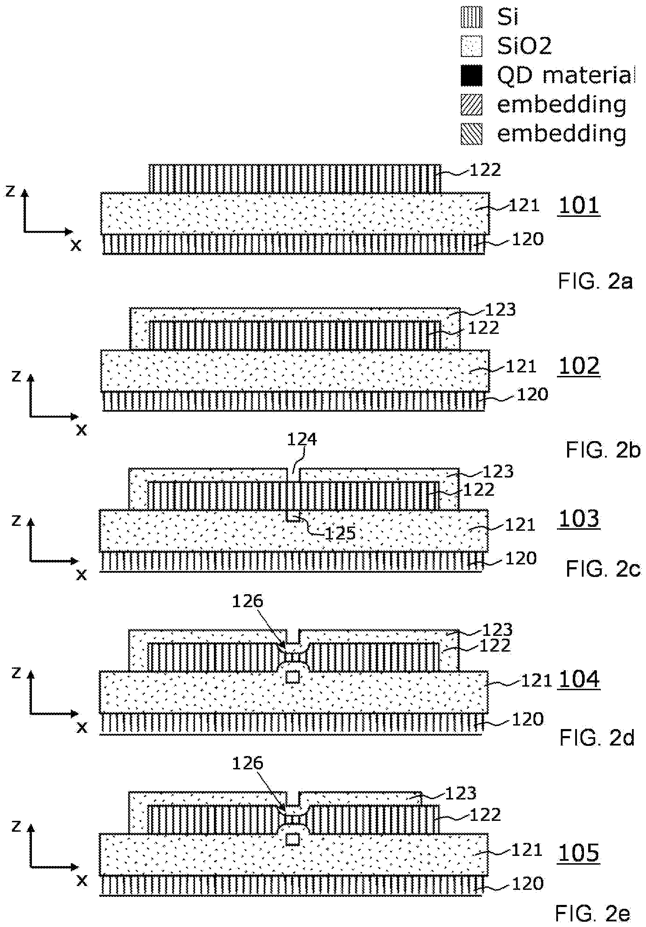

FIGS. 2a - 2j show corresponding enlarged cross-sectional views of the structures corresponding to the FIGS. 1a - 1j.

FIG. 1a illustrates a top view of an initial structure 101 and FIG. 2a illustrates a corresponding cross-sectional view.

The initial structure 101 includes a substrate 120. The substrate 120 includes a semiconductor material and may be e.g. a bulk semiconductor substrate. The substrate 120 may be embodied as a crystalline semiconductor or a compound semiconductor wafer of a large diameter. The substrate may include, for example, a material from group IV of the periodic table as semiconductor material. Materials of group IV include, for example, silicon (Si), germanium (Ge), mixed silicon and germanium, mixed silicon and carbon (C), mixed silicon germanium and carbon, and the like. For example, the substrate 120 may be a crystalline silicon wafer that is used in the semiconductor industry. For the following exemplary description, it is assumed that the substrate includes silicon (Si), which is illustrated by vertical stripes.

The structure 101 further includes an insulating layer 121 on the substrate 120. The insulating layer 121 may be embodied e.g. as a dielectric layer. The insulating layer 121 can be formed by known methods, as for example thermal oxidation, chemical vapor deposition (CVD), plasma enhanced CVD (PECVD), atomic layer deposition, chemical solution deposition, MOCVD, evaporation, sputtering and other deposition processes. Examples of such dielectric material include, but are not limited to: SiO2, Si3N4, Al2O3, AlON, Ta2O5, TiO2, La2O3, SrTiO3, LaAlO3, ZrO2, Y2O3, Gd2O3, MgO, MgNO, Hf-based materials and combinations including multilayers thereof.

For the following exemplary description, it is assumed that the insulating layer 121 includes SiO2 which is illustrated by a dotted pattern.

The structure 100 further includes a sacrificial structure 122 on the insulating layer 121. The sacrificial structure 122 includes or consists of a seed material. The seed material may be a group-IV or group-III-V material. The seed material may be in particular Si, which is illustrated in an exemplary way by vertical stripes. According to other embodiments the seed material may be a group-III-V compound material containing gallium (Ga) or indium (In).

The structure substrate 120, the insulating layer 121, and the sacrificial structure 122 may be in particular embodied as a silicon-on-insulator wafer.

The thicknesses of the substrate 120, the insulating layer 121 and the sacrificial structure 122 can be any suitable thicknesses. According to embodiments, the substrate 120 and the sacrificial structure 122 may consist of Si. The insulating layer 121 may consist of SiO2.

According to embodiments, the structure 101 including the substrate 120, the insulating layer 121, and the sacrificial layer 122 may be in particular embodied as a silicon-on-insulator wafer, in particular as a commercial SOI-wafer.

The sacrificial structure 122 has been patterned in a desired way. The sacrificial structure 122 forms the inner part of a cavity structure to be formed subsequently and will be replaced locally by another semiconductor material, in particular a group III-V semiconductor material. The sacrificial structure may be formed by lithography and subsequent etching. The etching may be based in particular on hydrogen bromide (HBr) chemistry, as known in the art, and used as standard technique in Si photonics. It has an advantage that it provides smooth sidewalls.

It should be noted that for ease of illustration the top views 1a-1j do not show the insulating layer 121 and the substrate 120.

FIG. 1b illustrates a top view of a structure 102 and FIG. 2b a corresponding cross-sectional view. The structure 102 has been formed from the structure 101 by encapsulating the sacrificial structure 122 in oxide. More particularly, the sacrificial structure 122 is covered with a coating layer 123 of a dielectric material. In the exemplary embodiment of FIGS. 1b and 2b it is assumed that the coating layer 123 includes SiO2 which is illustrated by a dotted pattern.

FIG. 1c illustrates a top view of a structure 103 and FIG. 2c a corresponding cross-sectional view. The structure 103 has been formed from the structure 102 by forming an opening 124 in the coating layer 123 at the envisaged position of the seed area 126 and the quantum dot structure (to be formed). The opening 124 may be formed in particular by an etching step. According to embodiments the etching may include an under-etching to form also an opening 125 below the sacrificial structure 122. The seed area 126 is positioned in a central part of the sacrificial structure 122.

FIG. 1d illustrates a top view of a structure 104 and FIG. 2d a corresponding cross-sectional view. The structure 104 has been formed from the structure 103 by performing a controlled oxidation of the seed material of the sacrificial structure 122 at the seed area 126. Thereby a controlled reduction of the cross section of the seed area 126 in the lateral y-direction and/or in the vertical z-direction is performed. According to such an embodiment the seed material of the sacrificial structure 122 may be in particular any suitable oxidizing material. According to embodiments, the seed area 126 may have a cross sectional area in the y-z-plane between 100 nm² and 4000 nm².

FIG. 1e illustrates a top view of a structure 105 and FIG. 2e a corresponding cross-sectional view. The structure 105 has been formed from the structure 104 by opening a first window 127 to the sacrificial structure 122. More particularly, the SiO2 of the coating layer 123 has been etched, e.g. by reactive ion etching (RIE), to give access to the sacrificial Si material.

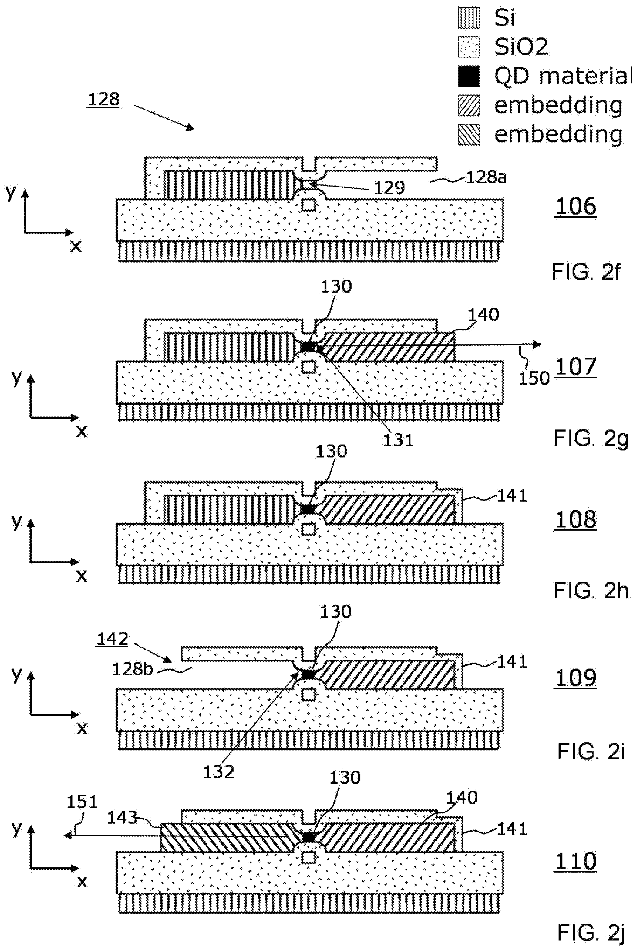

FIG. 1f illustrates a top view of a structure 106 and FIG. 2f a corresponding cross-sectional view. The structure 106 has been formed from the structure 105 by performing a selective removal of the seed material, in particular the Si, back to the desired position of the quantum dot structure. This has formed a first hollow cavity 128a of a cavity structure 128 for a subsequent growth step. The selective removal may be performed in particular by a selective etching technique, such as TMAH or XeF₂ based etchants. The first hollow cavity 128a includes a seed surface 129 of the seed material within the seed area 126.

FIG. 1g illustrates a top view of a structure 107 and FIG. 2g a corresponding cross-sectional view. The structure 107 has been formed from the structure 106 by growing within the cavity structure 128, more particularly within the first cavity 128a, a quantum dot structure 130 from the seed surface 129. Furthermore, a first embedding layer 140 has been grown from a first surface 131 of the quantum dot structure 130. The growing of the quantum dot structure 130 and the first embedding layer 140 establishes a first growth step. The first growth step includes a nucleation phase, a growth of the quantum dot structure 130 and a growth of the first embedding layer 140. The quantum dot structure 130 may be embodied in particular as single quantum dot. The growing of the quantum dot structure 130 and the first embedding layer 140 is performed in a first growth direction 150. The first growth direction 150 may be in particular a lateral direction.

The quantum dot structure 130 may include in particular a group III-V semiconductor material. The first embedding layer 140 may also include a group III-V semiconductor material.

According to embodiments, the dimensions of the quantum dot structure 130 may be in a range between 10 nm and 60 nm in all dimensions, i.e. in the x-direction, the y-direction and the z-direction.

FIG. 1h illustrates a top view of a structure 108 and FIG. 2h a corresponding cross-sectional view. The structure 108 has been formed from the structure 107 by encapsulating the first embedding layer 140 with a coating layer 141, in particular an oxide layer. The coating layer 141 may be much thinner than the coating layer 123 of the cavity structure 128.

FIG. 1i illustrates a top view of a structure 109 and FIG. 2i a corresponding cross-sectional view. The structure 109 has been formed from the structure 108 by opening a second window 142 to the sacrificial structure 122. More particularly, the SiO2 of the coating layer 123 is etched by RIE, to give access to the sacrificial Si material. Furthermore, a selective removal of the seed material, in particular the Si, back to the quantum dot structure 130 has been performed. This has formed a second hollow cavity 128b of the cavity structure 128 for a subsequent growth step. The selective removal may be performed in particular by a selective etching technique. The selective etching has formed a second surface 132 of the quantum dot structure 130. In other words, the sacrificial Si material is selectively removed back to position of the previous nucleation. The first surface 131 and the second surface 132 of the quantum dot structure 130 are arranged opposite to each other.

FIG. 1j illustrates a top view of a structure 110 and FIG. 2j a corresponding cross-sectional view. The structure 110 has been formed from the structure 110 by growing within the cavity structure 128, more particularly within the second cavity 128b, a second embedding layer 143 from the second surface 132 of the quantum dot structure 130. The growing of the second embedding layer 143 establishes a second growth step. The second growth step includes a nucleation phase and the growth of the second embedding layer 143.

The growing of the second embedding layer 143 is performed in a second growth direction 151. The first growth direction 150 and the second growth direction 151 are in particular lateral directions in the y-x-plane. The first growth direction 150 is in particular the opposite direction to the second growth direction 151.

The second embedding layer 143 may include in particular a group III-V semiconductor material.

According to embodiments, the quantum dot structure 130 may include a second semiconductor material, in particular a second group III-V semiconductor material, while the first and the second embedding layers 140, 143 may include a first semiconductor material, in particular a first group III-V semiconductor material. The first semiconductor material and the second semiconductor material may have a different bandgap to provide quantum confinement. In particular, the first semiconductor material of the first and the second embedding layer 140, 143 has a larger bandgap than the second semiconductor material of the quantum dot structure 130. One preferred combination of the first and the second group III-V semiconductor materials include InP as first semiconductor material of the embedding layers and InGaAs as second semiconductor material of the quantum dot structure. Other preferred combinations encompass AlGaAs combined with GaAs and GaAs combined with InGaAs. According to embodiments, the first embedding layer 140 may include a first semiconductor material and the second embedding layer 143 a third semiconductor material which is different from the first semiconductor material.

However, it should be noted that the group III-V materials may be generally binary as well as ternary or quaternary materials.

According to other embodiments, appropriate pairs of group II - VI semiconductor compounds, mixed II-VI compounds, and IV-VI compounds may be used.

According to embodiments, the quantum dot structure 130 may include a second semiconductor material, the first embedding layer 140 may include a doped semiconductor layer of a first semiconductor material and the second embedding layer 143 may include a doped semiconductor layer of the first semiconductor material or of a third semiconductor material.

According to embodiments the pairs first semiconductor material/second semiconductor material may be established in particular by the pairs InP / InGaAs; InP / InAlGaAs; GaAs / AlGaAs; GaAs / InAs; InP / InAsSb; GaN / InGaN or InAs / CdSe.

The growing of the quantum dot structure 130, the growing of the first embedding layer 140 and the growing of the second embedding layer 143 may be performed e.g. by metal organic chemical vapor deposition (MOCVD), by atmospheric pressure CVD, by low or reduced pressure CVD, by ultra-high vacuum CVD, by molecular beam epitaxy (MBE), by atomic layer deposition (ALD) or by hydride vapor phase epitaxy.

In general, the versatility of methods according to embodiments of the invention may allow any combination of group III-V semiconductor materials in the cavity structure 128, including embedded quantum wells, quantum dots, quantum wires, doped or intrinsic semiconductor layers as well as heterojunctions.

According to embodiments the quantum dot structure 130, the first embedding layer 140 and the second embedding layer 143 may form a gain structure. Such a gain structure has been epitaxially grown and extends in a lateral direction of the substrate, more particularly in the x-y-plane. The x-y-plane is arranged in parallel to the underlying substrate.

Hence the embodied gain structure may include a doping profile which forms a pi-n-structure. This may facilitate electrical pumping. A p-i-n-structure is a structure having an intrinsic region arranged between a p-doped region and a n-doped region.

In this respect, doping shall be understood as the intentional introduction of impurities into an intrinsic semiconductor for the purpose of modulating its electrical and optical and structural properties. Doping a semiconductor introduces allowed energy states within the band gap, but very close to the energy band that corresponds to the dopant type. Positive or p-type doping introduces free holes in the valence band, whereas negative or n-type doping introduces free electrons within the conduction band.

The introduction of dopants has the effect of shifting the energy bands relative to the Fermi level. In a n-type semiconductor the Fermi level is close to the conduction band, or within the conductance band in a degenerate n-type semiconductor. For p-type the Fermi level is close to the or within the valance band. Doping densities in typically doped semiconductors range from 5x10¹⁸ cm³ to 10²⁰ cm³, depending on the material and density of states. Whereas semiconductors are rarely perfectly intrinsic, intrinsic in the electrical sense means that they are not conductive. Typically, the doping level is around 10¹⁵ - 10¹⁶ cm³.

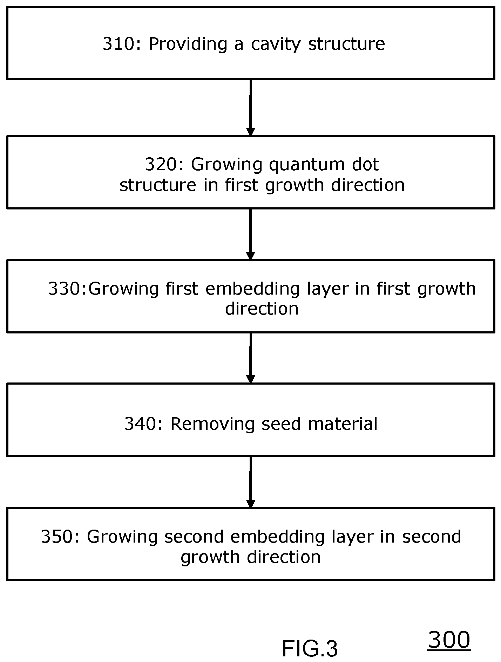

FIG. 3 shows a flow chart of method steps of a method for fabricating a semiconductor structure according to embodiments of the invention.

At a step 310, a cavity structure is provided. The cavity structure includes a seed area including a seed material.

At a step 320, a quantum dot structure is grown within the cavity structure in a first growth direction from a seed surface of the seed material.

At a step 330, a first embedding layer is grown in the first growth direction on a first surface of the quantum dot structure.

At a step 340, the seed material of the sacrificial structure is removed.

At a step 350, a second embedding layer is grown in a second growth direction within the cavity structure on a second surface of the quantum dot structure.

The second surface of the quantum dot structure is different from the first surface of the quantum dot structure and may be in particular opposite to the first surface of the quantum dot structure. The second growth direction is different from the first growth direction and may be in particular opposite to the first growth direction.

It should be noted that the step 350 may be followed by further processing steps as appropriate to derive at a final device structure as desired. This may include in particular a step of growing contact layers on the embedding layers.

While illustrative examples are given above, it will be appreciated that the basic fabrication steps described above can be used to produce semiconductor structures of other materials, shapes and sizes. Materials and processing techniques can be selected as appropriate for a given embodiment, and suitable choices will be readily apparent to those skilled in the art.

While particular examples have been described above, numerous other embodiments can be envisaged. The seed surfaces for growing the semiconductor structures may be preferably crystalline seed surfaces, but may according to other embodiments also be provided by amorphous surfaces. If the seed has a well-defined crystalline orientation and if the crystal structure of the seed is a reasonable match to that of the growing crystal (for example a III-V compound semiconductor), the growing crystal can adapt this orientation. If the seed is amorphous or has an undefined crystal orientation, the growing crystal will be single crystalline, but its crystal orientation will be random.

The disclosed semiconductor structures and circuits can be part of a semiconductor chip. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip may be integrated with other chips, discrete circuit elements, and/or other signal processing devices as part of either an intermediate product, such as a motherboard, or an end product. The end product can be any product that includes integrated circuit chips.

The following definitions and abbreviations are to be used for the interpretation of the claims and the specification. As used herein, the terms "includes," "comprising," "includes," "including," "has," "having," "contains" or "containing," or any other variation thereof, are intended to cover a non-exclusive inclusion. For example, a composition, a mixture, process, method, article, or apparatus that includes a list of elements is not necessarily limited to only those elements but can include other elements not expressly listed or inherent to such composition, mixture, process, method, article, or apparatus.

As used herein, the articles "a" and "an" preceding an element or component are intended to be nonrestrictive regarding the number of instances (i.e., occurrences) of the element or component. Therefore, "a" or "an" should be read to include one or at least one, and the singular word form of the element or component also includes the plural unless the number is obviously meant to be singular.

As used herein, the term "quantum dot structure" is a non-limiting term and shall refer to quantum well embodiments, quantum dots, in particular single quantum dots, and quantum wires.

As used herein, the terms "invention" or "present invention" are non-limiting terms and not intended to refer to any single aspect of the particular invention but encompass all possible aspects as described in the specification and the claims.

The descriptions of the various embodiments of the present invention have been presented for purposes of illustration, but are not intended to be exhaustive or limited to the embodiments disclosed. Many modifications and variations will be apparent to those of ordinary skill in the art without departing from the scope of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A method for fabricating a semiconductor device, the method comprising:
providing (310) a cavity structure (128), the cavity structure (128) comprising a seed area (126) comprising a seed material;
growing (320), within the cavity structure (128), a quantum dot structure (130) in a first growth direction (150) from a seed surface of the seed material;
growing (330), in the first growth direction (150), a first embedding layer (140) on a first surface (131) of the quantum dot structure (130);
removing (340) the seed material; and
growing (350), within the cavity structure (128), on a second surface (132) of the quantum dot structure (130), a second embedding layer (143) in a second growth direction (151), wherein the second surface (132) of the quantum dot structure (130) is different from the first surface (131) of the quantum dot structure (130) and the second growth direction (151) is different from the first growth direction (150);
wherein providing the cavity structure comprises: providing a semiconductor substrate; patterning a sacrificial structure on the semiconductor substrate, the sacrificial structure comprising the seed material; forming a coating layer comprising a coating material on the semiconductor substrate and the sacrificial structure; and selectively removing a first part of the seed material, thereby forming the seed surface, wherein the seed material is an oxidizing material and the method further comprises: forming an opening in the coating layer at the seed area; performing a controlled oxidation of the seed material at the seed area, thereby performing a controlled reduction of the cross section of the seed area.

2. The method according to claim 1, wherein the quantum dot structure comprises one or more quantum dots.

3. The method according to claim 1, wherein the first growth direction is an opposite direction to the second growth direction.

4. The method according to claim 1, wherein a position of the quantum dot structure is defined by the seed area.

5. The method according to claim 1, wherein the seed area has a cross sectional area between 100 nm² and 4000 nm².

6. The method according to claim 1, further comprising:
selectively removing a second part of the sacrificial structure, thereby providing the second surface of the quantum dot structure.

7. The method according to claim 1, wherein the seed area is formed in a central part of the cavity structure.

8. The method according to claim 1, wherein the seed material is a group-IV material, in particular Si.

9. The method according to claim 1, wherein the seed material is a III-V material containing a material selected from the group consisting of GaAs, InAs and InP.

10. The method according to claim 1, wherein the quantum dot structure comprises a group III-V semiconductor material.

11. The method according to claim 1, wherein the first embedding layer and the second embedding layer each comprise a group III-V semiconductor material.

12. The method according to claim 1, wherein
the first embedding layer comprises a doped semiconductor layer of a first semiconductor material;
the second embedding layer comprises a doped semiconductor layer of the first semiconductor material; and
the quantum dot structure comprises a second semiconductor material.

13. The method according to claim 12, wherein the first semiconductor material and the second semiconductor material are selected from pairs consisting of:
InP / InGaAs; InP / InAlGaAs; GaAs / AlGaAs; GaAs / InAs; InP / InAsSb; GaN / InGaN; and InAs / CdSe.

14. The method according to claim 1, wherein the growing of the quantum dot structure and the growing of the first and the second embedding layer is performed by one of: metal organic chemical vapor deposition (MOCVD); atmospheric pressure CVD; low or reduced pressure CVD; ultra-high vacuum CVD; molecular beam epitaxy (MBE); atomic layer deposition (ALD) and hydride vapor phase epitaxy.

15. The method according to claim 1, wherein selectively removing the first part of the seed material comprises performing a selective wet etching.

## Patentansprüche

1. Verfahren zur Herstellung einer Halbleitervorrichtung, wobei das Verfahren umfasst:
Bereitstellen (310) einer Vertiefungsstruktur (128), wobei die Vertiefungsstruktur (128) einen Keimbereich (126) aufweist, welcher ein Keimmaterial aufweist;
Züchten (320) einer Quantenpunktstruktur (130) innerhalb der Vertiefungsstruktur (128) in einer ersten Züchtungsrichtung (150) von einer Keimfläche des Keimmaterials aus;
Züchten (330) einer ersten Einbettungsschicht (140) auf einer ersten Fläche (131) der Quantenpunktstruktur (130) in der ersten Züchtungsrichtung (150);
Entfernen (340) des Keimmaterials; und
Züchten (350) einer zweiten Einbettungsschicht (143) innerhalb der Vertiefungsstruktur (128) auf einer zweiten Fläche (132) der Quantenpunktstruktur (130) in einer zweiten Züchtungsrichtung (151), wobei sich die zweite Fläche (132) der Quantenpunktstruktur (130) von der ersten Fläche (131) der Quantenpunktstruktur (130) unterscheidet und sich die zweite Züchtungsrichtung (151) von der ersten Züchtungsrichtung (150) unterscheidet;
wobei das Bereitstellen der Vertiefungsstruktur umfasst: Bereitstellen eines Halbleitersubstrats; Strukturieren einer Opferstruktur auf dem Halbleitersubstrat, wobei die Opferstruktur das Keimmaterial aufweist; Bilden einer Beschichtungsschicht, welche ein Beschichtungsmaterial aufweist, auf dem Halbleitersubstrat und der Opferstruktur; und selektives Entfernen eines ersten Teils des Keimmaterials, wodurch die Keimfläche gebildet wird, wobei das Keimmaterial ein oxidierendes Material ist und das Verfahren ferner umfasst: Bilden einer Öffnung in der Beschichtungsschicht an dem Keimbereich; Durchführen einer kontrollierten Oxidation des Keimmaterials an dem Keimbereich, wodurch eine kontrollierte Verringerung des Querschnitts des Keimbereichs durchgeführt wird.

2. Verfahren nach Anspruch 1, wobei die Quantenpunktstruktur einen oder mehrere Quantenpunkte aufweist.

3. Verfahren nach Anspruch 1, wobei die erste Züchtungsrichtung eine der zweiten Züchtungsrichtung entgegengesetzte Richtung ist.

4. Verfahren nach Anspruch 1, wobei eine Position der Quantenpunktstruktur durch den Keimbereich definiert ist.

5. Verfahren nach Anspruch 1, wobei der Keimbereich eine Querschnittsfläche von 100 nm² bis 4000 nm² aufweist.

6. Verfahren nach Anspruch 1, ferner umfassend:
selektives Entfernen eines zweiten Teils der Opferstruktur, wodurch die zweite Fläche der Quantenpunktstruktur bereitgestellt wird.

7. Verfahren nach Anspruch 1, wobei der Keimbereich in einem zentralen Teil der Vertiefungsstruktur gebildet wird.

8. Verfahren nach Anspruch 1, wobei das Keimmaterial ein Gruppe-IV-Material ist, insbesondere Si.

9. Verfahren nach Anspruch 1, wobei das Keimmaterial ein III-V-Material ist, welches ein Material enthält, das aus der Gruppe ausgewählt ist, die aus GaAs, InAs und InP besteht.

10. Verfahren nach Anspruch 1, wobei die Quantenpunktstruktur ein Gruppe-III-V-Halbleitermaterial aufweist.

11. Verfahren nach Anspruch 1, wobei die erste Einbettungsschicht und die zweite Einbettungsschicht jeweils ein Gruppe-III-V-Halbleitermaterial aufweisen.

12. Verfahren nach Anspruch 1, wobei
die erste Einbettungsschicht eine dotierte Halbleiterschicht eines ersten Halbleitermaterials aufweist;
die zweite Einbettungsschicht eine dotierte Halbleiterschicht des ersten Halbleitermaterials aufweist; und
die Quantenpunktstruktur ein zweites Halbleitermaterial aufweist.

13. Verfahren nach Anspruch 12, wobei das erste Halbleitermaterial und das zweite Halbleitermaterial aus Paaren ausgewählt sind, bestehend aus:
InP / InGaAs; InP / InAlGaAs; GaAs / AlGaAs; GaAs / InAs; InP / InAsSb; GaN / InGaN; und InAs / CdSe.

14. Verfahren nach Anspruch 1, wobei das Züchten der Quantenpunktstruktur und das Züchten der ersten und der zweiten Einbettungsschicht durch eines aus Folgendem durchgeführt wird: Metallorganische chemische Abscheidung aus der Gasphase (Metal Organic Chemical Vapor Deposition, MOCVD); Atmosphärendruck-CVD; CVD bei niedrigem oder verringertem Druck; Ultrahochvakuum-CVD; Molekularstrahlepitaxie (Molecular Beam Epitaxy, MBE); Atomschichtabscheidung (Atomic Layer Deposition, ALD) und Hydrid-Gasphasenepitaxie.

15. Verfahren nach Anspruch 1, wobei das selektive Entfernen des ersten Teils des Keimmaterials Durchführen eines selektiven Nassätzens umfasst.

## Revendications

1. Procédé de fabrication d'un dispositif à semiconducteurs, le procédé comprenant :
la mise à disposition (310) d'une structure de cavité (128), la structure de cavité (128) comprenant une zone de germination (126) comprenant un matériau de germination ;
la croissance (320), à l'intérieur de la structure de cavité (128), d'une structure de points quantiques (130) dans une première direction de croissance (150) à partir d'une surface de germination du matériau de germination ;
la croissance (330), dans la première direction de croissance (150), d'une première couche d'incorporation (140) sur une première surface (131) de la structure de points quantiques (130) ;
le retrait (340) du matériau de germination ; et
la croissance (350), à l'intérieur de la structure de cavité (128), sur une seconde surface (132) de la structure de points quantiques (130), d'une seconde couche d'incorporation (143) dans une seconde direction de croissance (151), dans laquelle la seconde surface (132) de la structure de points quantiques (130) est différente de la première surface (131) de la structure de points quantiques (130) et la seconde direction de croissance (151) est différente de la première direction de croissance (150) ;
dans lequel la mise à disposition de la structure de cavité comprend : la mise à disposition d'un substrat semiconducteur ; l'arrangement d'une structure sacrificielle sur le substrat semiconducteur, la structure sacrificielle comprenant le matériau de germination ; la formation d'une couche de revêtement comprenant un matériau de revêtement sur le substrat semiconducteur et la structure sacrificielle ; et le retrait sélectif d'une première partie du matériau de germination, formant ainsi la surface de germination, dans lequel le matériau de germination est un matériau oxydant et le procédé comprend en outre : la formation d'une ouverture dans la couche de revêtement au niveau d'une zone de germination ; la réalisation d'une oxydation contrôlée du matériau de germination au niveau de la zone de germination, formant ainsi une réduction contrôlée de la section transversale de la zone de germination.

2. Procédé selon la revendication 1, dans lequel la structure de points quantiques comprend un ou plusieurs points quantiques.

3. Procédé selon la revendication 1, dans lequel la première direction de croissance est en direction opposée à la seconde direction de croissance.

4. Procédé selon la revendication 1, dans lequel une position de la structure de points quantiques est définie par la zone de germination.

5. Procédé selon la revendication 1, dans lequel la zone de germination a une surface de section transversale entre 100 nm² et 4000 nm².

6. Procédé selon la revendication 1, comprenant en outre :
le retrait sélectif d'une seconde partie de la structure sacrificielle, mettant ainsi en place la seconde surface de la structure de points quantiques.

7. Procédé selon la revendication 1, dans lequel la zone de germination est formée dans une partie centrale de la structure de cavité.

8. Procédé selon la revendication 1, dans lequel le matériau de germination est un matériau du groupe IV, en particulier Si.

9. Procédé selon la revendication 1, dans lequel le matériau de germination est un matériau III-V contenant un matériau choisi dans le groupe constitué de GaAs, InAs et InP.

10. Procédé selon la revendication 1, dans lequel la structure de points quantiques comprend un matériau semiconducteur du groupe III-V.

11. Procédé selon la revendication 1, dans lequel la première couche d'incorporation et la seconde couche d'incorporation comprennent chacune un matériau semiconducteur du groupe III-V.

12. Procédé selon la revendication 1, dans lequel
la première couche d'incorporation comprend une couche semiconductrice dopée d'un matériau semiconducteur ;
la seconde couche d'incorporation comprend une couche semiconductrice dopée du premier matériau semiconducteur ; et
la structure de points quantiques comprend un second matériau semiconducteur.

13. Procédé selon la revendication 12, dans lequel le premier matériau semiconducteur et le second matériau semiconducteur sont sélectionnés parmi des paires constituées de :
InP / InGaAs ; InP / InAlGaAs ; GaAs / AlGaAs ; GaAs / InAs ; InP / InAsSb ; GaN / InGaN et InAs / CdSe.

14. Procédé selon la revendication 1, dans lequel la croissance de la structure de points quantiques et la croissance de la première et de la seconde couche d'incorporation sont effectuées par l'une des techniques suivantes : dépôt chimique en phase vapeur par composés organométalliques (MOCVD) ; CVD sous pression atmosphérique ; CVD à faible pression ou pression réduite ; CVD sous ultravide ; épitaxie par jet moléculaire (MBE) ; dépôt par couches atomiques (ALD) et épitaxie en phase vapeur d'hydrures.

15. Procédé selon la revendication 1, dans lequel le retrait sélectif de la première partie du matériau de germination comprend la réalisation d'une gravure humide sélective.
